# EUROPÄISCHE PATENTSCHRIFT

(11) **EP 0 563 609 B1**
(45) Veröffentlichungstag und Bekanntmachung des Hinweises auf die Patenterteilung: **25.09.1996**
(21) Anmeldenummer: 93103449.0
(22) Anmeldetag: 04.03.1993
(51) Int. Cl.: H01J 37/34, H01J 37/32

(54) **Vorrichtung zum Erzeugen eines Plasmas mittels Kathodenzerstäubung und Mikrowelleneinstrahlung**
Device for producing plasma using cathodic sputtering and microwave radiation
Dispositif pour la production d'un plasma au moyen d'une pulvérisation cathodique et d'un rayonnement microondes

(30) Priorität: 28.03.1992 DE 4210284
(43) Veröffentlichungstag der Anmeldung: 06.10.1993
(73) Patentinhaber: LEYBOLD AKTIENGESELLSCHAFT, D-63450 Hanau (DE)
(72) Erfinder: Latz, Rudolf, Dr., D-45891 Gelsenkirchen (DE); Ritter, Jochen, Dipl.-Ing., W-6312 Laubach (Hessen) (DE); Scherer, Michael, Dr., W-6458 Rodenbach (DE); Gegenwart, Reiner, Dr., W-6074 Rödermark (DE)
(74) Vertreter: Schickedanz, Willi, Dipl.-Ing.

(56) Entgegenhaltungen:
- EP-A- 0 173 164
- DE-A- 3 920 834
- REVIEW OF SCIENTIFIC INSTRUMENTS. Bd. 63, Nr. 1, Januar 1992, NEW YORK US Seiten 179 - 183 Y. YOSHIDA 'Microwave enhanced magnetron sputtering.'
- IBM TECHNICAL DISCLOSURE BULLETIN. Bd. 33, Nr. 7, 7. Dezember 1990, NEW YORK US Seiten 169-170 'ECR-sputter source for deposition of metals at very low pressures'

## Beschreibung

Auf zahlreichen Gebieten der Technik ist es erforderlich, dünne Schichten auf Substrate aufzubringen. Beispielsweise werden Glasscheiben beschichtet, um ihnen zu besonderen Eigenschaften zu verhelfen, oder es werden Uhrengehäuse aus einem weniger edlen Material mit einer aus edlem Material bestehenden Schicht überzogen.

Für das Aufbringen dünner Schichten auf Substrate sind bereits zahlreiche Verfahren vorgeschlagen worden, von denen lediglich die Galvanotechnik und das Beschichten aus einem Plasma heraus erwähnt seien. Das Beschichten aus dem Plasma hat in den letzten Jahren immer mehr an Bedeutung gewonnen, weil es eine Vielzahl von Materialien als Beschichtungsmaterial zuläßt.

Um ein für die Beschichtung geeignetes Plasma herzustellen, sind ebenfalls verschiedene Verfahren vorgeschlagen worden. Von diesen Verfahren ist das Kathodenzerstäubungsverfahren, das auch Sputtern genannt wird, wegen seiner hohen Beschichtungsraten von großem Interesse. Die Beschichtungsraten lassen sich mit dem Sputtern noch erhöhen, wenn in den Raum vor der zerstäubten Kathode eine Mikrowelle eingestrahlt wird.

Es sind bereits mehrere Vorrichtungen für ein mikrowellenunterstütztes Sputtern bekannt (US-A-4 610 770, US-A-4 721 553, DE-A-3 920 834). Hierbei werden die Mikrowellen entweder parallel oder senkrecht oder in einem bestimmten Winkel zur Substratoberfläche in den Plasmabereich eingeführt. Durch das Zusammenwirken des Magnetfelds des Magnetrons mit den Mikrowellen kann eine Elektronenzyklotronresonanz (ECR) hergestellt werden, welche die Teilchen des Plasmas verstärkt ionisiert.

Nachteilig ist bei den meisten bekannten Vorrichtungen indessen, daß die ECR-Bedingung in der Nähe der Sputterkathode auftritt, wo die Anregung der Teilchen nicht so notwendig ist wie im Bereich des Substrats. Um diesen Nachteil zu beheben, wird bei der Vorrichtung gemäß DE-A-3 920 834 die Mikrowelle auf ein Substrat gestrahlt, das seinerseits von den Feldlinien eines Dauermagneten durchdrungen ist. Hierdurch ist direkt über dem Substrat die ECR-Bedingung erfüllt. Allerdings kann bei dieser bekannten Vorrichtung eine Plasmaentladung nur bis zu einer bestimmten Mindestspannung und bis zu einem bestimmten Mindestdruck erfolgen. Selbst durch sehr starke Magnetfelder an der Targetoberfläche läßt sich die Plasma-Brennspannung nicht mehr erniedrigen. Hohe Entladespannungen führen aber zu unerwünschten Effekten, z. B. dem Einbau von Edelgasen in die Substratstruktur oder zu Strahlenschäden.

Es ist weiterhin eine Sputteranlage bekannt, die sowohl mit einer Mikrowelle als auch mit einem ebenen Magnetron arbeitet (Y. Yoshida: Microwave-enhanced magnetron sputtering, Rev. Sci. Instrum. 63 (1), January 1992, S. 179 - 182). Das Magnetrontarget ist hierbei an dem offenen Ende eines aufgespreizten inneren Leiters eine Koaxialkabels angeordnet, und zwar parallel zum offenen Austrittsende des inneren Leiters. Der aufgespreizte äußere Mantel des Koaxialkabels endet dagegen unmittelbar über der Kathodenoberfläche, so daß die aus ihm austretenden Mikrowellen parallel zur Kathodenoberfläche verlaufen. Nachteilig ist bei dieser bekannten Sputteranlage indessen, daß die Kathode kreissymmetrisch ist, was wiederum kreisringförmige Dauermagnete des Magnetrons bedingt.

Schließlich ist auch noch eine Sputteranlage bekannt, mit der Siliziumschichten mittels einer planaren Magnetronkathode, die drei Targets aufweist, auf einem Substrat aufgebracht werden (T. Serikawa und A. Okamoto: Sputter depositions of silicon film by a planar magnetron cathode equipped with three targets, J. Vac. Sci. Technol. A 3 (4), Jul/Aug 1985, S. 1784 - 1787). Durch die Verwendung von drei Targets statt einem Target sollen die Schwierigkeiten umgangen werden, die daraus resultieren, daß es schwieriger ist, große Targets ohne störende Einschlüsse herzustellen. Die hierbei zum Einsatz kommende Kathode weist einen Stützkörper auf, auf dem die Targets ruhen, die vom Targethalter am Stützkörper festgehalten werden. Außerdem sind unterhalb des Stützkörpers drei ringförmige Dauermagnete vorgesehen. Zwischen den Targets und am Rande der Targets sind geerdete Abschirmungen vorgesehen. Auch bei dieser bekannten Sputteranordnung sind die Targets bzw. ist die Kathode rund. Dies ist insbesondere für den In-Line-Betrieb nachteilig.

Der Erfindung liegt deshalb die Aufgabe zugrunde, Magnetron-Kathoden bereitszustellen, die bei niedrigen Entladespannungen und/oder Arbeitsdrücken für den In-Line-Betrieb geeignet sind.

Diese Aufgabe wird gemäß den Merkmalen des Patentanspruchs 1 gelöst.

Der mit der Erfindung erzielte Vorteil besteht insbesondere darin, daß bei einer hohen Plasmadichte und bei relativ geringer Teilchenenergie Entladungen bereits mit geringen Kathodenspannungen möglich sind. Auch die Drücke, bei denen die Entladungen einsetzen, sind sehr gering. Bei reaktiven Prozessen führt darüber hinaus die Aktivierung der reaktiven Teilchen zu einer deutlichen Reduktion des Reaktivgaspartialdrucks. Wird z. B. Sauerstoff als Reaktivgas verwendet, so verringern sich die unerwünschten Rücksputtereffekte. Weiterhin ist es aufgrund der Verwendung einer Rechteckkathode möglich, einen In-Line-Betrieb zu realisieren und/oder einen Anschluß zu bereits vorhandenen Standardkathoden herzustellen.

Ein Ausführungsbeispiel der Erfindung ist in der Zeichnung dargestellt und wird im folgenden näher beschrieben. Es zeigen:
- Fig. 1: eine Plasmakammer mit einer Magnetronkathode und einer Mikrowelleneinstrahlung;
- Fig. 2: eine perspektivische Schnittdarstellung des Einstrahlungsbereichs der Mikrowelle in die Plasmakammer;
- Fig. 3: eine Teilbereich-Darstellung der Vorrichtung gemäß Fig. 2, bei der die Hohlleiter nicht geschnitten dargestellt sind;
- Fig. 4: eine Kurvendarstellung, welche die Abhängigkeit von Sputterstrom und Kathodenspannung bei einer Vorrichtung gemäß Fig. 1 wiedergibt.

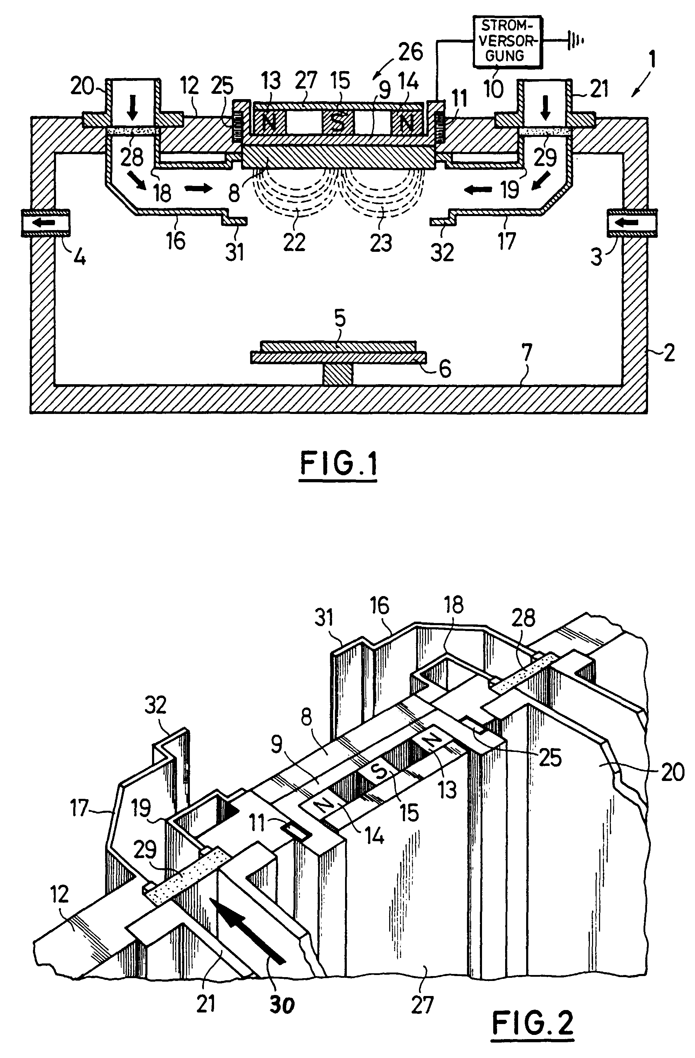

In der Fig. 1 ist eine Plasmakammer 1 dargestellt, deren Gehäuse 2 einen Gaseinlaß 3 und einen Gasauslaß 4 aufweist. In diesem Gehäuse 2 befindet sich ein zu beschichtendes Substrat 5 auf einem Drehteller 6, der am Boden 7 des Gehäuses 2 angeordnet ist. Gegenüber dem Substrat 5 ist eine Sputterelektrode 8 vorgesehen, die mit einer Kathodenwanne 9 in Verbindung steht. Die Sputterelektrode 8 stellt ein sogenanntes "Target" dar, das z. B. aus Indiumoxid besteht, das einen Sauerstoffanteil von mindestens 5 % hat und das mit Zinn oder Zinnoxid dotiert ist. An die Kathodenwanne 9 ist eine Stromversorgung 10 angeschlossen, bei der es sich vorzugsweise um eine Gleichstromversorgung handelt. Die Kathodenwanne 9 sitzt auf elektrischen Isolatoren 11, 25, die ihrerseits in einer Aussparung auf der Oberseite 12 des Gehäuses 2 eingelassen sind.

In der Kathodenwanne 9 ist ein Dauermagnet 26 mit einem Joch 27 und zwei Nordpolen 13, 14 sowie einem zwischen diesen liegenden Südpol 15 angeordnet. Auf beiden Seiten der Sputterelektrode 8 ist jeweils ein Hohlleiter 16, 17 vorgesehen, dessen Längsachse parallel zur Oberfläche der Sputterelektrode 8 verläuft und der in einem U-förmigen Blech 31, 32 endet. Jeder dieser beiden Hohlleiter 16, 17 weist eine 90-Grad-Knickstelle 18, 19 auf, an der er nach oben abgewinkelt ist und über einen Flansch 20, 21 mit einem nicht dargestellten Mikrowellensender in Verbindung steht. Zwischen dem Flansch 20, 21 und dem Hohlleiter 16, 17 ist eine Quarzscheibe 28, 29 vorgesehen, welche die Plasma- oder Vakuumkammer 1 von der Außenwelt druckmäßig abtrennt. Durch die Anordnung von Nord- und Südpol des Dauermagneten bilden sich kreisbogenförmige magnetische Feldlinien 22, 23 aus, in denen bei einstrahlenden Mikrowellen die ECR-Bedingung erfüllt sein kann. Die Hohlleiter 16, 17 leiten die Mikrowellenenergie über die U-förmigen Bleche 31, 32 direkt in den Bereich zwischen Target 8 und Substrat 5, wo sie absorbiert wird. Es versteht sich, daß durch den Gaseinlaß ein Edelgas, z. B. Argon, und/oder ein Reaktivgas, z. B. Sauerstoff, eingelassen werden kann. Bei der in der Fig. 1 gezeigten Anordnung genügen bereits geringe Spannungen der Stromversorgung 10, um z. B. bei einem Druck von 1 µbar zu einer Glimmentladung zu führen. Kommt ein reaktives Gas zum Einsatz, so kann der Reaktionsgaspartialdruck erheblich reduziert werden, was im Fall von Sauerstoff unerwünschte Rücksputtereffekte verringert. Dies ist insbesondere beim Beschichten mit Hochtemperatursupraleitern oder mit Indium- oder Zinnoxidschichten von Bedeutung.

Die Speisung der Flansche 20, 21 mit Mikrowellenenergie kann auf verschiedene Weise erfolgen. So ist es beispielsweise möglich, daß ein einziger Mikrowellensender für beide Flansche vorgesehen ist. Von diesem Mikrowellensender führt in diesem Fall ein Hohlleiter weg, der in ein T-Stück zum Aufzweigen der Mikrowelle mündet. Von diesem T-Stück führt dann ein erster Hohlleiter zu dem Flansch 20 und ein zweiter Hohlleiter zu dem Flansch 21. Zwischen dem T-Stück und den Flanschen 20, 21 ist vorzugsweise noch ein Abstimmungsglied, z. B. ein Dreistab, vorgesehen, das als Empfangstuner wirkt.

Statt eines einzigen Mikrowellensenders für die beiden Flansche 20, 21 kann jedoch ein eigener Mikrowellensender für jeden Flansch vorgesehen sein. Auch in diesem Fall ist zwischen dem Mikrowellensender und dem Flansch ein Abstimmungsglied in den Reckteckhohlleiter eingepaßt.

In der Fig. 2 ist der obere Bereich der Plasmakammer 1 noch einmal in perspektivischer Darstellung gezeigt. Man erkennt hierbei deutlich, wie die Mikrowelle - die durch einen Pfeil 30 angedeutet ist - durch die Quarzscheibe 29 in den Hohlleiter 17 gelangt, von wo aus sie über das Blech 32 in Richtung auf die Unterseite der Sputterelektrode 8 abgelenkt wird. Bei der Sputterelektrode 8 handelt es sich um eine langgestreckte rechteckige Elektrode. Entsprechend ist auch das Blech 32 langgestreckt gebildet.

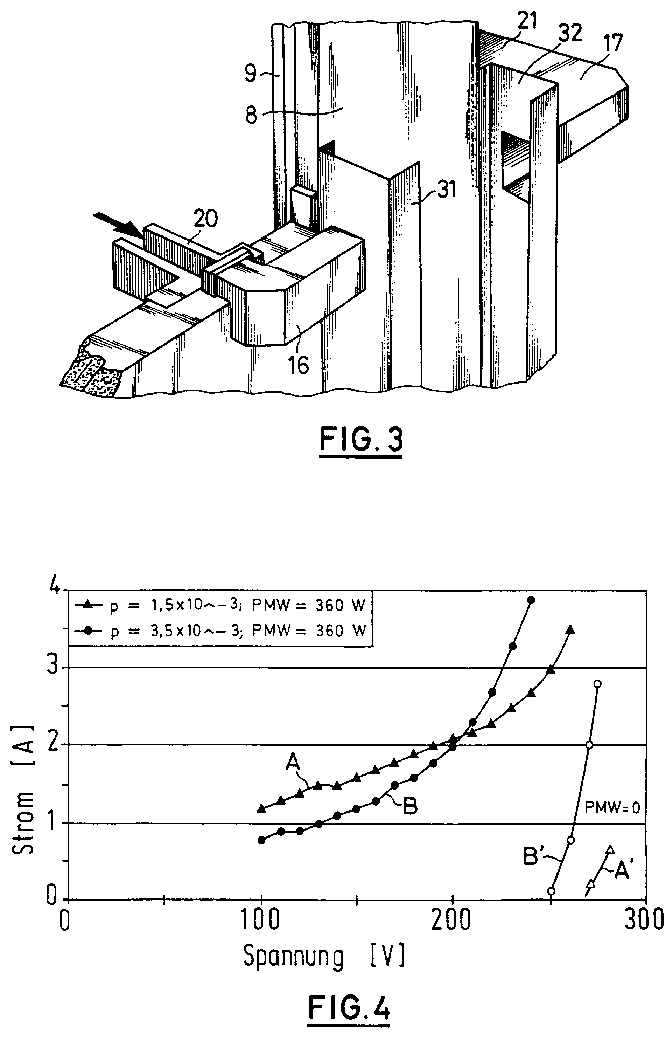

Aus der Fig. 3 ist ersichtlich, daß die Hohlleiter 16, 17 nur über einen kleinen Bereich des Blechs 31, 32 angekoppelt sind, das sich über die ganze Sputterelektrode 8 hin erstreckt.

Die Fig. 4 zeigt die Abhängigkeit zwischen dem Entladestrom und der Sputterspannung bei einer Vorrichtung gemäß den Fig. 1 bis 3. Bei der Sputterspannung handelt es sich um die Spannung zwischen dem Substrat 5 und dem Target 8, während der Entladestrom der aus der Stromversorgung in die Elektrodenwanne 9 fließende Strom ist. Die Meßkurve A gibt das Strom-Spannungsverhältnis bei einem Druck von 1,5 x 10⁻³ mbar an, wohingegen die Meßkurve B das Strom-Spannungsverhältnis bei einem Druck von 3,5 x 10⁻³ mbar zeigt. In beiden Fällen beträgt die Mikrowellenleistung 360 W.

Die Kurven A' und B' sind bei den gleichen Druckwerten gemessen, jedoch ohne gleichzeitige Mikrowellenleistung. Wenn die Mikrowellenleistung Null ist, liegt die untere Brennspannung bei 250 V bzw. 270 V, je nachdem, ob ein Druck von 3,5 x 10⁻³ mbar oder ein Druck von 1,5 x 10⁻³ mbar herrscht.

Wird dagegen eine Mikrowellenleistung von 360 W eingespeist, so Fällt die Brennspannung auf einen Wert kleiner als 100 Volt.

Die Frequenz der eingespeisten Mikrowelle beträgt vorzugsweise 2,45 GHz, während die magnetische Induktion B der Magnetronkathode vor dem Sputter-Target 8 ca. 875 Gauss beträgt. Außer dem Magnetfeld der Magnetronkathode kann die erfindungsgemäße Vorrichtung auch noch weitere Magnetfelder aufweisen. Beispielsweise kann parallel zur Kammerwand 2 ein Magnetfeld vorgesehen sein, das so ausgerichtet ist, daß das Substrat zwischen diesem Magnetfeld und den Magnetfeldern 22, 23 zu liegen kommt.

Mit der Vorrichtung kann in besonders vorteilhafter Weise Indiumoxid gesputtert werden, das mit Zinn dotiert ist (JTO). Die Strom-Spannungskennlinien hierfür sind in der Fig. 4 gezeigt. Das Magnetfeld der Kathode an der Targetoberfläche hat hierbei ungefähr 1000 Gauss. Die Abhängigkeit des Entladestroms von der Entladespannung ist bei mikrowellenunterstütztem Sputtern für einen Prozeßgasdruck von 1,5 x 10⁻³ mbar durch fette Dreiecke und für einen Prozeßgasdruck von 3,5 x 10⁻³ mbar durch volle Kreise gekennzeichnet. Die entsprechenden Kurven ohne Mikrowellenunterstützung sind durch leere Dreiecke und Kreise dargestellt. Ohne Mikrowellenunterstützung liegt die untere Brennspannung bei 250 V bzw. 270 V, je nach Druck. Im Falle, daß die Leistung 360 W beträgt, ist eine Brennspannung kleiner als 100 Volt möglich.

## Patentansprüche

1. Vorrichtung zum Erzeugen eines Plasmas mittels Kathodenzerstäubung und Mikrowelleneinstrahlung, mit
a) einer Vakuumkammer (1), in die ein Inertgas und/oder Reaktivgas einbringbar ist,
b) einem Target (8) in dieser Vakuumkammer (1), das mit einer Elektrode (9) verbunden ist, die an einer Stromversorgung liegt,
c) einem Magnetsystem (13 bis 15), dessen Magnetfeld aus dem Target (8) austritt und in dieses wieder eintritt,
d) einem Mikrowellensender, der über Wellenleiter (20, 21) und eine mikrowellendurchlässige Gassperre (28, 29) in den Bereich vor dem Target (8) Mikrowellen sendet, wobei die Mikrowellen im wesentlichen parallel zur Oberfläche des Targets (8) eingestrahlt werden,
**dadurch gekennzeichnet,** daß
e) das Target (8) eine rechteckig begrenzte und ebene Oberfläche aufweist, wobei die eine Rechteckseite kurz und die andere lang ist,
f) zwei einander gegenüberliegende Kathoden-Abschirmkästen (31, 32) vorgesehen sind, die sich entlang der langen Target-Rechteckseiten erstrecken und durch die Mikrowellen parallel zur Targetoberfläche von einander gegenüberliegenden Seiten eingespeist werden können,
g) zwei Hohlleiter (16, 17) vorgesehen sind, die die Mikrowellen zu den Kathoden-Abschirmkästen (31, 32) leiten und deren Abmessungen senkrecht zur Oberfläche des Targets (8) kleiner sind als die der Kathoden-Abschirmkästen (31, 32) in derselben Richtung und die in die jeweiligen Kathoden-Abschirmkästen (31, 32) übergehen und Mikrowellen parallel zur Oberfläche des Targets (8) von einander gegenüberliegenden Seiten einspeisen.

2. Vorrichtung nach Anspruch 1, **dadurch gekennzeichnet,** daß als Gassperre ein Quarzglas dient, welches den mit der Vakuumkammer (1) in Verbindung stehenden Teil des Hohlleiters (16, 17) von einem mit Atmosphäre in Verbindung stehenden Teil (20, 21) des Hohlleiters druckmäßig trennt.

3. Vorrichtung nach Anspruch 1, **dadurch gekennzeichnet,** daß sich die Hohlleiter (16, 17) und die Kathodenabschirmkästen (31, 32) über die ganze Länge der Elektrode (9) erstrecken.

4. Vorrichtung nach Anspruch 1, **dadurch gekennzeichnet,** daß die Querschnittsfläche der Hohlleiter (20, 21, 16, 17) nur einen Bruchteil der Elektrode (9) überdeckt und sich die an die Hohlleiter anschließenden Kathodenabschirmkästen (31, 32) über die ganze Länge der Kathode (9) erstrecken.

5. Vorrichtung nach Anspruch 1, **dadurch gekennzeichnet**, daß die Kathodenabschirmkästen (31, 32) jeweils eine Öffnung für den Austritt von Mikrowellen aus dem Hohlleiter (16,17) in den Raum vor dem Target (8) aufweisen.

6. Vorrichtung nach Anspruch 1, **dadurch gekennzeichnet**, daß auf der Oberseite (12) der Vakuumkammer (1) eine Öffnung vorgesehen ist, durch welche der Hohlleiter (20, 21, 16, 17) in die Vakuumkammer (1) eingeführt ist, und daß der Hohlleiter (16, 17) anschließend um 90 Grad abgewinkelt ist.

7. Vorrichtung nach Anspruch 1, **dadurch gekennzeichnet**, daß gegenüber dem Target (8) ein Substrat (5) angeordnet ist.

8. Vorrichtung nach Anspruch 1, **dadurch gekennzeichnet**, daß die Mikrowellenfrequenz vorzugsweise 2,45 GHz und die magnetische Induktion B an der Oberfläche des Targets (8) mindestens 875 Gauss beträgt.

9. Vorrichtung nach Anspruch 1, **dadurch gekennzeichnet**, daß das Magnetron drei magnetische Polaritäten (13, 15, 14) über die Breite der Elektrode (9) aufweist, die sich über die gesamte Länge der Elektrode (9) erstrecken, wobei zwei dieser Polaritäten (z. B. 14, 13) gleiches Vorzeichen haben.

10. Vorrichtung nach Anspruch 1, **dadurch gekennzeichnet**, daß im Bereich des Substrats (5) und parallel zur Kammerwand (2) eine zusätzliche Magnetfeldanordnung vorgesehen ist.

11. Vorrichtung nach Anspruch 1, **dadurch gekennzeichnet**, daß das Target (8) aus Indiumoxid besteht, dessen Sauerstoffdefizit mindestens 5 % beträgt, und daß das Indiumoxid mit Zinn oder Zinnoxid dotiert ist.

12. Vorrichtung nach Anspruch 1, **dadurch gekennzeichnet**, daß ein Mikrowellensender vorgesehen ist, der über Hohlleiter mit den Teilstücken (20, 21) verbunden ist.

13. Vorrichtung nach Anspruch 1, **dadurch gekennzeichnet**, daß zwei Mikrowellensender vorgesehen sind, von denen der eine über einen ersten Hohlleiter mit dem ersten Teilstück (20) und der andere über einen zweiten Hohlleiter mit dem zweiten Teilstück (21) verbunden ist.

14. Vorrichtung nach Anspruch 12 oder Anspruch 13, **dadurch gekennzeichnet**, daß in den Hohlleitern, die von dem Mikrowellensender zu den Teilstücken (20, 21) führen, jeweils ein Abstimmglied vorgesehen ist, das die Mikrowelle weitgehend verlustfrei in das Plasma der Vakuumkammer (1) einkoppelt.

15. Vorrichtung nach Anspruch 3, **dadurch gekennzeichnet**, daß bei sehr langen Kathoden mehrere identische Hohlleiter und Kathodenabschirmkästen vorgesehen sind, die sich als kombinierte Einheit über die Länge der Elektrode (9) erstrecken.

## Claims

1. A device for generating a plasma by means of cathodic sputtering and microwave irradiation, having
a) a vacuum chamber (1) into which an inert gas and/or reactive gas may be introduced,
b) a target (8) in this vacuum chamber (1), which is connected to an electrode (9) provided with a power supply,
c) a magnetic system (13 to 15) whereof the magnetic field emerges from the target (8) and re-enters the latter,
d) a microwave emitter which emits microwaves into the region in front of the target (8) by way of waveguides (20, 21) and a microwave-transparent means (28, 29) of blocking out gases, the microwaves passing substantially parallel to the surface of the target (8),
characterized in that
e) the target (8) has a rectangularly delimited and planar surface, the one side of the rectangle being short and the other long,
f) there are provided two mutually opposing cathode shielding casings (31, 32) which extend along the long sides of the target rectangle and through which the microwaves may be fed from mutually opposing sides, parallel to the target surface,
g) there are provided two waveguides (16, 17) which guide the microwaves to the cathode shielding casings (31, 32), and of which the dimensions perpendicular to the surface of the target (8) are smaller than those of the cathode shielding casings (31, 32) in the same direction, and which merge into the respective cathode shielding casings (31, 32) and feed microwaves from mutually opposing sides, parallel to the surface of the target (8).

2. A device according to Claim 1, characterized in that there serves as the means of blocking out gases a quartz glass which separates, in terms of pressure, the part of the waveguide (16, 17) which is in contact with the vacuum chamber (1) from a part (20, 21) of the waveguide which is in contact with the atmosphere.

3. A device according to Claim 1, characterized in that the waveguides (16, 17) and the cathode shielding casings (31, 32) extend over the entire length of the electrode (9).

4. A device according to Claim 1, characterized in that the cross-sectional surface of the waveguides (20, 21, 16, 17) only covers a fraction of the electrode (9), and the cathode shielding casings (31, 32) adjoining the waveguides extend over the entire length of the cathode (9).

5. A device according to Claim 1, characterized in that the cathode shielding casings (31, 32) each have an opening for the emergence of microwaves from the waveguide (16, 17) into the space in front of the target (8).

6. A device according to Claim 1, characterized in that there is provided on the upper side (12) of the vacuum chamber (1) an opening through which the waveguide (20, 21, 16, 17) is inserted into the vacuum chamber (1), and in that the waveguide (16, 17) is then turned through 90°.

7. A device according to Claim 1, characterized in that a substrate (5) is arranged opposite the target (8).

8. A device according to Claim 1, characterized in that the microwave frequency is preferably 2.45 GHz and the magnetic induction B at the surface of the target (8) is at least 875 gauss.

9. A device according to Claim 1, characterized in that the magnetron has three magnetic polarities (13, 15, 14) over the width of the electrode (9), which polarities (13, 15, 14) extend over the entire length of the electrode (9), two of these polarities (e.g. 14, 13) having the same sign.

10. A device according to Claim 1, characterized in that an additional magnetic field arrangement is provided in the region of the substrate (5) and parallel to the chamber wall (2).

11. A device according to Claim 1, characterized in that the target (8) is of indium oxide whereof the oxygen deficit is at least 5%, and in that the indium oxide is doped with tin or tin oxide.

12. A device according to Claim 1, characterized in that there is provided a microwave emitter which is connected to the sections (20, 21) by way of waveguides.

13. A device according to Claim 1, characterized in that there are provided two microwave emitters, of which one is connected to the first section (20) by way of a first waveguide and of which the other is connected to the second section (21) by way of a second waveguide.

14. A device according to Claim 12 or Claim 13, characterized in that there is provided in the waveguides leading from the microwave emitter to the sections (20, 21) in each case a tuning member which launches the microwave into the plasma in the vacuum chamber (1) in a manner largely free of loss.

15. A device according to Claim 3, characterized in that there are provided in the case of very long cathodes a plurality of identical waveguides and cathode shielding casings which extend over the length of the electrode (9) in the form of a combined unit.

## Revendications

1. Dispositif pour la fabrication d'un plasma par pulvérisation cathodique et par rayonnements micro-ondes, comprenant
a) une enceinte à vide (1) dans laquelle un gaz inerte et/ou un gaz réactif peut être incorporé,
b) une cible (8) dans cette enceinte à vide (1) qui est reliée à une électrode (9) branchée à une alimentation de courant,
c) un système d'aimants (13 à 15) dont le champ magnétique entre et sort de la cible (8),
d) un émetteur de micro-ondes qui émet, dans la zone devant la cible (8), des micro-ondes par l'intermédiaire de guides d'ondes (20, 21) et d'un barrage gazeux (28, 29) perméable aux micro-ondes, les micro-ondes rayonnant sensiblement parallèlement à la surface de la cible (8),
caractérisé en ce que
e) la cible (8) présente une surface plane et limitée de manière rectangulaire, la face du rectangle étant courte et l'autre longue,
f) deux caissons de blindage de cathode (31, 32), se trouvant l'un au-dessus de l'autre, sont prévus pour s'étendre le long des faces longues de la cible rectangulaire et peuvent être alimentés en micro-ondes parallèlement à la surface de la cible, depuis des faces mutuellement opposées,
g) il est prévu deux guides d'ondes (16, 17) qui orientent les micro-ondes en direction des caissons de blindage de cathode (31, 32), dont les dimensions perpendiculaires à la surface de la cible (8) sont plus petites que celles des caissons de blindage de cathode (31, 32) dans la même direction qui se transforment en caisson respectif de blindage de cathode (31, 32) et qui fournissent, parallèlement à la surface de la cible (8) des micro-ondes, depuis des faces mutuellement opposées.

2. Dispositif selon la revendication 1, caractérisé en ce que le barrage gazeux est constitué par un verre quartzeux qui sépare en pression la partie du guide d'ondes (16, 17), connectée à l'enceinte à vide (1), d'une partie (20, 21) du guide d'ondes, qui se trouve en contact avec l'atmosphère.

3. Dispositif selon la revendication 1, caractérisé en ce que le guide d'ondes (16, 17) et les caissons de blindage de cathode (31, 32) s'étendent sur toute la longueur de l'électrode (9).

4. Dispositif selon la revendication 1, caractérisé en ce que la surface de section transversale des guides d'ondes (20, 21, 16, 17) ne recouvre qu'une fraction de l'électrode (9) et en ce que les caissons de blindage de cathode (31, 32) s'étendent dans le prolongement des guides d'ondes sur toute la longueur de la cathode (9).

5. Dispositif selon la revendication 1, caractérisé en ce que les caissons de blindage de cathode (31, 32) présentent respectivement une ouverture pour la sortie des micro-ondes depuis le guide d'ondes (16, 17) pour parvenir devant la cible (8).

6. Dispositif selon la revendication 1, caractérisé en ce que sur la face supérieure (12) de l'enceinte à vide (1), il est prévu une ouverture par laquelle est inséré le guide d'ondes (20, 21, 16, 17) dans l'enceinte à vide (1) et en ce que le guide d'ondes (16, 17) est ensuite coudé à 90°.

7. Dispositif selon la revendication 1, caractérisé en ce qu'un substrat (5) est disposé en face de la cible (8).

8. Dispositif selon la revendication 1, caractérisé en ce que la fréquence de micro-ondes est de préférence de 2,45 GHz et l'induction magnétique B à la surface de la cible (8) d'au moins 875 Gauss.

9. Dispositif selon la revendication 1, caractérisé en ce que le magnétron présente trois polarités magnétiques (13, 15, 14) sur la largeur de l'électrode (9), lesquelles s'étendent sur toute la longueur de l'électrode (9), deux de ces polarités (par exemple 14, 13) ayant le même signe.

10. Dispositif selon la revendication 1, caractérisé en ce que dans la zone du substrat (5) et parallèlement à la paroi d'enceinte (2), il est prévu une disposition de champ magnétique supplémentaire.

11. Dispositif selon la revendication 1, caractérisé en ce que la cible (8) se compose d'oxyde d'indium dont le déficit en azote est d'au moins 5 % et en ce que l'oxyde d'indium est dopé à l'étain ou à l'oxyde d'étain.

12. Dispositif selon la revendication 1, caractérisé en ce qu'il est prévu un émetteur de micro-ondes qui est relié aux parties de guide (20, 21) par l'intermédiaire du guide d'ondes.

13. Dispositif selon la revendication 1, caractérisé en ce que deux émetteurs de micro-ondes sont prévus dont l'un est relié à la première partie (20) par l'intermédiaire d'un premier guide d'ondes et l'autre à la seconde partie (21) par l'intermédiaire d'un second guide d'ondes.

14. Dispositif selon la revendication 12 ou la revendication 13, caractérisé en ce que dans les guides d'ondes qui relient l'émetteur de micro-ondes aux parties (20, 21), il est prévu un organe de syntonisation qui introduit des micro-ondes à peu près sans perte dans le plasma de l'enceinte à vide (1).

15. Dispositif selon la revendication 3, caractérisé en ce que dans le cas de cathodes très longues, plusieurs guides d'ondes creux identiques et des caissons de blindage de cathode sont prévus qui s'étendent en tant q'unité combinée sur la longueur de l'électrode (9).
